# EUROPEAN PATENT APPLICATION

(11) **EP 4 618 592 A1**
(43) Date of publication of application: **17.09.2025**
(21) Application number: 23947137.8
(22) Date of filing: 03.08.2023
(51) Int. Cl.: H04R 3/00

(54) **AUDIO PROCESSING DEVICE AND METHOD**

(71) Applicant: Shenzhen Shokz Co., Ltd., Shenzhen, Guangdong 518108 (CN)
(72) Inventor: QIU, Jingbo, Shenzhen, Guangdong 518108 (CN); WANG, Liang, Shenzhen, Guangdong 518108 (CN); TIAN, Qingyuan, Shenzhen, Guangdong 518108 (CN)
(74) Representative: Fuchs Patentanwälte Partnerschaft mbB
(86) International application number: PCT/CN2023/110885
(87) International publication number: WO 2025/025189

(57) **Abstract**

This specification provides an audio processing device and method. The audio processing device includes a sound-emitting module and an audio processing module, the sound-emitting module includes N sound-emitting units, and each sound-emitting unit outputs an audio signal of a predetermined frequency band during operation; after obtaining initial audio data, the audio processing module performs frequency division processing on the initial audio data to obtain at least M sub-audio data of corresponding M sub-frequency bands, each sub-frequency band corresponds to the predetermined frequency band output by the corresponding sound-emitting unit among the N sound-emitting units, audio adjustment is performed on the corresponding M sub-audio data according to target audio characteristics of the M sub-audio data respectively to obtain M adjusted audio data, and each adjusted audio data is then input to the corresponding sound-emitting unit respectively. The technical solution of the embodiments of this specification can improve the sound quality effect of audio processing of multiple sound-emitting units.

## Description

### Technical Field

This specification relates to the field of audio processing, and particularly relates to an audio processing device and method.

### Background Art

With the development of true wireless Bluetooth headset technology, people have increasingly higher requirements for the sound quality of headsets.

In related technical solutions, audio data is directly sent to an audio playback device such as a headset's sound-emitting unit for audio playback. However, since mainstream headsets basically use a single sound-emitting unit, a single sound-emitting unit can hardly achieve a better audio playback effect, that is to say, a single sound-emitting unit leads to a poor sound quality effect of audio processing.

Therefore, how to improve the sound quality effect of audio played by an audio playback device has become an urgent technical problem to be solved.

The content of the background art section is merely information known to the inventor personally and does not represent that the above information has entered the public domain before the filing date of this disclosure, nor does it represent that it can become the prior art of this disclosure.

### Summary of the Invention

This specification provides an audio processing device and method capable of improving the sound quality effect of audio played by an audio playback device.

In a first aspect, this specification provides an audio processing device, comprising: a sound-emitting module, comprising N sound-emitting units, wherein each of the sound-emitting units outputs an audio signal of a predetermined frequency band during operation, wherein N is an integer greater than 1; and an audio processing module, in communication with the sound-emitting module, wherein the audio processing module is configured to: obtain initial audio data, perform frequency division processing on the initial audio data to obtain at least M sub-audio data of corresponding M sub-frequency bands, wherein each sub-frequency band corresponds to the predetermined frequency band output by corresponding sound-emitting unit among the N sound-emitting units, wherein M is an integer greater than 1, perform audio adjustment on each of the corresponding M sub-audio data according to target audio characteristics of the M sub-audio data to obtain M adjusted audio data, and input each adjusted audio data of the M adjusted audio data to the corresponding sound-emitting unit respectively.

In some exemplary embodiments, to perform the audio adjustment on the M sub-audio data respectively, the audio processing module is configured to, for each of the sub-audio data: perform the audio adjustment on the sub-audio data according to an audio adjustment model corresponding to the target audio characteristics of the sub-audio data, wherein the audio adjustment model corresponds to the sub-frequency band in which the sub-audio data is located.

In some exemplary embodiments, the target audio characteristics comprise volume gain; before performing the audio adjustment on the sub-audio data, the audio processing module is further configured to: obtain a volume gain of the sub-audio data of the sub-frequency band; and determine the audio adjustment model corresponding to the sub-audio data of the sub-frequency band according to a correspondence between the volume gain and the audio adjustment model.

In some exemplary embodiments, the volume gain comprises a plurality of volume levels, and different volume levels among of the plurality of volume levels correspond to different audio adjustment models.

In some exemplary embodiments, the audio processing module is further configured to, for each sub-frequency band in the M sub-frequency bands: obtain adjusted audio data of a predetermined time length as sample data; compare audio data of the sample data with reference audio data, wherein the reference audio data is audio data corresponding to a reference audio curve of the audio adjustment model corresponding to the sub-frequency band; and adjust a model parameter of the audio adjustment model according to a comparison result.

In some exemplary embodiments, the audio processing module is further configured to obtain an update backup corresponding to the reference audio data of the audio adjustment model, and update the reference audio data according to the update backup.

In some exemplary embodiments, the audio adjustment model is an equalizer adjustment model, and the model parameter is an equalizer parameter.

In some exemplary embodiments, the N sound-emitting units comprise a bone conduction sound-emitting unit and an air conduction sound-emitting unit, wherein the bone conduction sound-emitting unit outputs mid-high frequency audio signals during operation, and the air conduction sound-emitting unit outputs low-frequency audio signals during operation.

In some exemplary embodiments, the initial audio data comprise audio data of K channels, and a frequency band interval of each channel comprises m sub-frequency bands, wherein m=M/K, and K is an integer greater than or equal to 1.

In some exemplary embodiments, the K channels comprise a left channel and a right channel, the m sub-frequency bands corresponding to the left channel comprise left channel mid-high frequencies and left channel low frequencies, and the m sub-frequency bands corresponding to the right channel comprise right channel mid-high frequencies and right channel low frequencies.

In some exemplary embodiments, a correspondence between channels and sound-emitting units comprises at least one of a one-to-many relationship, or a many-to-one relationship.

In some exemplary embodiments, the audio processing device is a headphone.

In a second aspect, this specification provides an audio processing method, the method is applied to an audio processing device, the audio processing device comprises N sound-emitting units, each of the sound-emitting units is configured to output an audio signal of a predetermined frequency band, wherein N is an integer greater than 1, the method comprising: obtain initial audio data; perform frequency division processing on the initial audio data to obtain at least M sub-audio data corresponding to M sub-frequency bands, wherein each sub-frequency band corresponds to the predetermined frequency band output by a corresponding sound-emitting unit among the N sound-emitting units, and M is an integer greater than 1; perform audio adjustment on the M sub-audio data according to target audio characteristics of the M sub-audio data to obtain M adjusted audio data; and input each adjusted audio data of the M adjusted audio data to the corresponding sound-emitting unit respectively.

In some exemplary embodiments, the performing of the audio adjustment on the M sub-audio data respectively comprises, for each sub-audio data: performing the audio adjustment on the sub-audio data according to the audio adjustment model corresponding to the target audio characteristics of the sub-audio data, wherein the audio adjustment model corresponds to the sub-frequency band where the sub-audio data is located.

In some exemplary embodiments, the target audio characteristics comprise volume gain; before performing the audio adjustment on the sub-audio data, the method further comprises: obtaining a volume gain of the sub-audio data of the sub-frequency band; and determining the audio adjustment model corresponding to the sub-audio data of the sub-frequency band according to a correspondence between the volume gain and the audio adjustment model.

In some exemplary embodiments, the volume gain comprises a plurality of volume levels, and different volume levels among of the plurality of volume levels correspond to different audio adjustment models.

In some exemplary embodiments, the method further comprises: for each sub-frequency band in the M sub-frequency bands: obtaining adjusted audio data of a predetermined time length as sample data; comparing audio data of the sample data with reference audio data, wherein the reference audio data is audio data corresponding to a reference audio curve of the audio adjustment model corresponding to the sub-frequency band; and adjusting a model parameter of the audio adjustment model according to a comparison result.

In some exemplary embodiments, the audio adjustment model is an equalizer adjustment model, and the model parameter is an equalizer parameter.

In some exemplary embodiments, the N sound-emitting units comprise a bone conduction sound-emitting unit and an air conduction sound-emitting unit, wherein the bone conduction sound-emitting unit outputs mid-high frequency audio signals during operation, and the air conduction sound-emitting unit outputs low-frequency audio signals during operation.

In some exemplary embodiments, the initial audio data comprise audio data of K channels, and a frequency band interval of each channel comprises m sub-frequency bands, wherein m=M/K, and K is an integer greater than or equal to 1.

In some exemplary embodiments, the K channels comprise a left channel and a right channel, the m sub-frequency bands corresponding to the left channel comprise left channel mid-high frequencies and left channel low frequencies, and the m sub-frequency bands corresponding to the right channel comprise right channel mid-high frequencies and right channel low frequencies.

It can be seen from the above technical solutions that the audio processing device, audio processing method, and system provided by the embodiments of this specification, on the one hand, perform frequency division processing on the initial audio data to obtain M sub-audio data of corresponding M sub-frequency bands, where each sub-frequency band corresponds to the predetermined frequency band output by one sound-emitting unit among the N sound-emitting units, which can adapt the sub-frequency band where the sub-audio data is located to the working frequency band of the sound-emitting unit, thereby improving the sound quality effect of the audio played by the sound-emitting unit; on the other hand, according to the target audio characteristics of the sub-audio data, audio adjustment is performed on the sub-audio data, and the adjusted audio data is input to the corresponding sound-emitting unit, which can perform audio adjustment on the sub-audio data to be played by the sound-emitting unit according to the audio characteristics of the sub-audio data, so that the audio characteristics of the adjusted audio data of the sub-frequency band are more suitable for the audio characteristics of the corresponding sound-emitting unit, thereby ensuring that the sound emitted by each sound-emitting unit in the sound-emitting module has a better sound-emitting effect, and thus further improving the sound quality effect of the audio played by the sound-emitting unit.

Other functions of the audio processing device and method provided in this specification will be partially listed in the following description. According to the description, the content introduced in the following figures and examples will be obvious to a person of ordinary skill in the art. The creative aspects of the audio processing device and method provided in this specification can be fully explained through practice or use of the methods, devices, and combinations described in detail in the examples below.

### Brief Description of the Drawings

To describe the technical solutions in the embodiments of this specification more clearly, the accompanying drawings that need to be used in the description of the embodiments will be briefly introduced below. Obviously, the accompanying drawings in the following description are only some embodiments of this specification, and for a person of ordinary skill in the art, other accompanying drawings can also be obtained according to these accompanying drawings without creative effort.
FIG. 1 is a schematic diagram of an application scenario of an audio processing device according to some embodiments of this specification;
FIG. 2 is a hardware structural diagram of an audio processing device according to some embodiments of this specification;
FIG. 3 is a schematic structural diagram of an audio processing module according to some embodiments of this specification;
FIG. 4 is a schematic structural diagram of an audio processing module according to some embodiments of this specification;
FIG. 5 is a schematic structural diagram of an audio processing module according to some embodiments of this specification;
FIG. 6 is a schematic structural diagram of an audio processing module according to some embodiments of this specification;
FIG. 7 is a schematic structural diagram of an audio processing device according to some embodiments of this specification;
FIG. 8 is a schematic flowchart of an audio processing method according to some embodiments of this specification;
FIG. 9 is a schematic flowchart of an audio processing method according to some embodiments of this specification; and
FIG. 10 is a schematic flowchart of a process for adjusting model parameters of an audio adjustment model according to some embodiments of this specification.

### Description of the Embodiments

The following description provides specific application scenarios and requirements of this specification for the purpose of enabling a person skilled in the art to manufacture and use the content of this specification. For a person skilled in the art, various local modifications to the disclosed embodiments will be obvious, and the general principles defined herein can be applied to other embodiments and applications without departing from the spirit and scope of this specification. Therefore, this specification is not limited to the embodiments shown, but rather to the widest scope consistent with the claims.

The terminology used herein is for the purpose of describing specific exemplary embodiments only and is not restrictive. For example, unless the context clearly indicates otherwise, the singular forms "a," "an," and "the" as used herein may also include plural forms. When used in this specification, the terms "comprise," "include," and/or "contain" mean that the associated integer, step, operation, element, and/or component is present, but do not exclude the presence of one or more other features, integers, steps, operations, elements, components, and/or groups, or that other features, integers, steps, operations, elements, components, and/or groups may be added to the system/method.

In view of the following description, these and other features of this specification, as well as the operation and function of related elements of the structure, and the combination of parts and economies of manufacture, can be significantly improved. With reference to the drawings, all of which form a part of this specification. However, it should be clearly understood that the drawings are for purposes of illustration and description only and are not intended to limit the scope of this specification. It should also be understood that the drawings are not drawn to scale.

The flowcharts used in this specification illustrate operations implemented by systems according to some embodiments of this specification. It should be clearly understood that the operations of the flowcharts may be implemented out of order. On the contrary, operations may be implemented in reverse order or simultaneously. Additionally, one or more other operations may be added to the flowcharts. One or more operations may be removed from the flowcharts.

Before describing the specific embodiments of this specification, the application scenarios of this specification are introduced as follows.

This specification relates to the usage scenarios of audio processing equipment. An exemplary usage scenario is as follows: After the audio processing device acquires the initial audio data output by the target device, it performs frequency division processing on the initial audio data to obtain sub-audio data of M sub-frequency bands, and plays the target sub-audio data corresponding to the sub-frequency bands through the corresponding sound-emitting units among N sound-emitting units, thereby forming a reverberant sound, where M and N are both integers greater than 1.

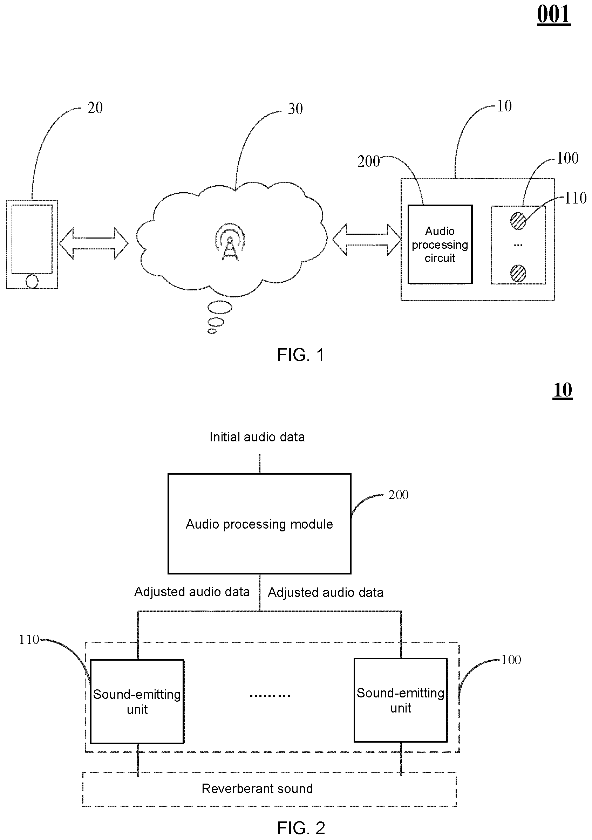

FIG. 1 illustrates a schematic diagram of an application scenario of an audio processing device provided according to some embodiments of this specification. As shown in FIG. 1, the application scenario 001 may include an audio processing device 10, a target device 20, and a network 30.

The audio processing device 10 may include a sound-emitting module 100 and an audio processing module 200. The sound-emitting module 100 includes N sound-emitting units 110, each sound-emitting unit 110 outputting an audio signal of a predetermined frequency band during operation, where N is an integer greater than 1. The audio processing module 200 may be communicatively connected to the sound-emitting module 100. The audio processing module 200 may acquire initial audio data from the target device 20, perform frequency division processing on the initial audio data to obtain sub-audio data of M sub-frequency bands, and play the sub-audio data corresponding to the sub-frequency bands through the corresponding sound-emitting units 110 among the N sound-emitting units 110 of the sound-emitting module 100, thereby forming a reverberant sound. In some embodiments, the audio processing device 10 may store data or instructions for executing the audio processing method described in this specification and may execute or be used to execute the aforementioned data or instructions. In some embodiments, the audio processing device 10 may include hardware devices with data information processing functions and the necessary programs required to drive the operation of such hardware devices. For example, the audio processing device 10 may be earphones, large-scale home or commercial audio systems, etc. The aforementioned audio processing method will be introduced in the subsequent content of this document.

The target device 20 may be an electronic device with audio data output functionality. In some embodiments, the target device 20 may include a mobile device, tablet computer, laptop computer, built-in/on board device of a motor vehicle, or similar content, or any combination thereof. In some embodiments, the mobile device may include smart home devices, smart mobile devices, virtual reality devices, augmented reality devices, or similar devices, or any combination thereof. In some embodiments, the smart home devices may include smart TVs, desktop computers, smart speakers, etc., or any combination thereof. In some embodiments, the smart mobile devices may include smartphones, personal digital assistants, gaming devices, navigation devices, etc., or any combination thereof. In some embodiments, the virtual reality devices or augmented reality devices may include virtual reality helmets, virtual reality glasses, virtual reality controllers, augmented reality helmets, augmented reality glasses, augmented reality controllers, or similar content, or any combination thereof. For example, the aforementioned virtual reality devices or augmented reality devices may include head-mounted glasses, head-mounted displays, etc. In some embodiments, the built-in devices in the motor vehicle may include in-vehicle computers, in-vehicle TVs, etc. In some embodiments, the target device 20 may include an audio collection device for collecting audio data within a target space, thereby obtaining initial audio data. In some embodiments, the target device 20 may also receive initial audio data from other devices.

In some embodiments, the target device 20 may have one or more applications (APPs) installed. The aforementioned APPs can provide users with the ability and interface to interact with the outside world. The aforementioned APPs include, but are not limited to: web browser APPs, search APPs, chat APPs, shopping APPs, video APPs, financial management APPs, instant messaging tools, email clients, social platform software, and so on. In some embodiments, a target APP may be installed on the target device 20. The aforementioned target APP can generate or acquire initial audio data, or the aforementioned target APP can receive initial audio data from other devices.

The network 30 serves as a medium to provide a communication connection between the audio processing device 10 and the target device 20. The network 30 can facilitate the exchange of information or data. As shown in FIG. 1, the audio processing device 10 and the target device 20 can be connected to the network 30 and transmit information or data to each other through the network 30. In some embodiments, the network 30 can be any type of wireless network. For example, the network 30 may include a telecommunications network, intranet, internet, local area network (LAN), wide area network (WAN), wireless local area network (WLAN), metropolitan area network (MAN), public switched telephone network (PSTN), Bluetooth^{™} network, ZigBee^{™} network, near field communication (NFC) network, or similar networks. For instance, if the network 30 is a Bluetooth^{™} network, in this case, the audio processing device 10 can be an audio processing device supporting the Bluetooth^{™} protocol; the target device 20 can be an audio data output device supporting the Bluetooth^{™} protocol. The audio processing device 10 can communicate with the target device 20 based on the Bluetooth^{™} protocol. In some embodiments, the audio processing device 10 can also perform data transmission with the target device 20 through a wired network or a local area network.

It should be understood that the number of audio processing devices 10, target devices 20, and networks 30 in FIG. 1 is merely illustrative. Depending on implementation needs, there can be any number of audio processing devices 10, target devices 20, and networks 30.

FIG. 2 illustrates a hardware structure diagram of an audio processing device 10 provided according to some embodiments of this specification. As shown in FIG. 2, the audio processing device 10 may include: a sound-emitting module 100 and an audio processing module 200.

In some embodiments, the sound-emitting module 100 may include N sound-emitting units 110, where N is an integer greater than 1. Each sound-emitting unit 110 outputs an audio signal of a predetermined frequency band during operation. The sound-emitting unit 110 may include one or more devices capable of producing sound; for example, the sound-emitting unit 110 may include one or more speakers. Different sound-emitting units 110 are used to output audio data of different frequency bands. In other words, different sound-emitting units 110 may have different operating frequency bands. For instance, some sound-emitting units 110 have audio characteristics that provide better reproduction of mid-frequency audio data and/or produce a thicker and/or smoother sound quality (thick and/or butter-like sound quality), and these sound-emitting units 110 operate in the mid-frequency band; some sound-emitting units 110 have audio characteristics that offer better reproduction of high-frequency audio data and/or produce a pure and clear sound quality, and these sound-emitting units 110 operate in the high-frequency band.

Taking the example where the sound-emitting unit 110 includes a bone conduction sound-emitting unit and an air conduction sound-emitting unit, the bone conduction sound-emitting unit has better sound effects for mid- and high-frequency audio data, so the predetermined frequency band, i.e., the operating frequency band, for the bone conduction sound-emitting unit is the mid-high frequency band(s); whereas the air conduction sound-emitting unit has better sound production effects for low-frequency audio data, so the predetermined frequency band, i.e., the operating frequency band, for the air conduction sound-emitting unit is the low-frequency band. For the human ear, the low-frequency band generally refers to the range of approximately 20 Hz to 150 Hz, the mid-frequency band generally refers to the range of approximately 150 Hz to 5 KHz, the high-frequency band generally refers to the range of approximately 5 KHz to 20K Hz, the mid-low frequency bands generally refers to the range of approximately 150 Hz to 500 Hz, and the mid-high frequency band(s) generally refers to the range of approximately 500 Hz to 5K Hz.

A person of ordinary skill in the art should understand that the division of the above frequency bands is merely provided as an example to roughly indicate ranges. The definitions of the above frequency bands may vary depending on different industries, different application scenarios, and different classification standards. For instance, in some other application scenarios, the low-frequency band may refer to the range of approximately 20 Hz to 80 Hz, the mid-low frequency bands may refer to the range of approximately 80 Hz to 160 Hz, the mid-frequency band may refer to the range of approximately 160 Hz to 1280 Hz, the mid-high frequency band(s) may refer to the range of approximately 1280 Hz to 2560 Hz, and the high-frequency band may refer to the range of approximately 2560 Hz to 20K Hz.

Further, the audio processing module 200 is configured to acquire initial audio data, perform frequency division processing on the initial audio data to obtain at least M sub-audio data corresponding to M sub-frequency bands, where M is an integer greater than 1, and M is greater than or equal to N. Each sub-frequency band corresponds to the predetermined frequency band output by the corresponding sound-emitting unit among the N sound-emitting units, meaning that each of the M sub-frequency bands is adapted to the operating frequency band of the corresponding sound-emitting unit 110. For example, if a sound-emitting unit 110 can produce clear sound quality in the high-frequency band but has average sound performance in the mid- and low-frequency bands, the predetermined frequency band (i.e., operating frequency band) for this sound-emitting unit 110 is the high-frequency band, and the sub-audio data corresponding to this sound-emitting unit will contain more high-frequency audio data, with less or even no audio data in the mid- and low-frequency bands.

The initial audio data may be digitized audio data of one or multiple channels. This initial audio data may include Pulse Code Modulation (PCM) audio data or other types of digitized audio data. Taking PCM audio data as an example, the initial audio data may be a binary sequence directly formed by converting an analog signal through analog-to-digital conversion. The audio processing module 200 may acquire the initial audio data in various ways. For example, the audio processing module 200 may directly receive the initial audio data sent by the target device 20, or it may receive the initial audio data sent by an audio collection device, or it may acquire at least one audio data from a preset audio data set as the initial audio data, or it may also acquire raw audio data. Then, the audio processing module 200 may select audio data of one or multiple channels from the raw audio data as the initial audio data. Alternatively, the audio processing module 200 may also include an audio collection circuit. The audio processing module 200 may collect audio data through the audio collection circuit and perform analog-to-digital conversion on the collected raw audio data to obtain the initial audio data.

In some exemplary embodiments, the initial audio data includes audio data of K channels, where K is an integer greater than or equal to 1. For example, let K=2, where the two channels include a left channel and a right channel. The spectral range of each channel may be the same; for instance, the spectral range of the left channel and the right channel may be identical. In other exemplary embodiments, there may be channels among the K channels with a spectral range different from that of other channels. For example, let K=6, where the six channels include five full-bandwidth channels and one low-frequency channel, with the spectral range of the five full-bandwidth channels being 3-20K Hz and the spectral range of the one low-frequency channel being 3-120 Hz.

Further, in some exemplary embodiments, the spectrum of the audio data of each of the K channels may include m sub-frequency bands, where m = M/K, and the i-th sound-emitting unit 110 among the N sound-emitting units 110 has a desired sound effect in the j-th predetermined frequency band, where i is an integer in [1, N], and j is an integer in [1, m]. Taking the spectrum of the initial audio data distributed in [20 Hz, 20K Hz] as an example, the m sub-frequency bands may completely cover the entire spectrum or may cover pre-set spectral ranges such as high-frequency, mid-frequency, and low-frequency. The m sub-frequency bands may have overlapping frequency ranges, or they may be completely independent frequency bands, and so on.

It should be noted that, although the explanation is given with the example that each channel corresponds to the same number of sub-frequency bands, a person skilled in the art should understand that different channels may also correspond to different numbers of sub-frequency bands, which is also within the scope of the embodiments of this specification.

Further, in some exemplary embodiments, frequency division processing of the initial audio data can be performed through software, or it can be performed through hardware. Below, the two frequency division processing methods, software frequency division processing and hardware frequency division processing, will be described in detail.

### 1. Software frequency division processing

The audio processing module 200 may include at least one processor. The processor can execute instructions in a frequency division processing instruction set and use a frequency division processing algorithm to perform frequency division processing on the initial audio data of K channels to obtain m sub-audio data of m sub-frequency bands for each channel. Herein, M=K*m, K is an integer greater than or equal to 1. For example, if the initial audio data has 2 channels and there are 4 sound-emitting units, with each channel corresponding to 2 sound-emitting units and 2 sub-frequency bands, then M=N=4, K=2, and m=2.

Taking the frequency division processing of the initial audio data of the j-th channel as an example, for the i-th sub-frequency band of the j-th channel, the amplitude on the i-th sub-frequency band is retained, and the amplitude under other sub-frequency bands is attenuated to obtain the sub-audio data of the i-th sub-frequency band of the j-th channel, where i is any integer in [1, m], and j is any integer in [1, K]; or, for the i-th sub-frequency band of the j-th channel, the audio data of the i-th sub-frequency band is retained, and the audio data of other sub-frequency bands is filtered out to obtain the sub-audio data of the i-th sub-frequency band of the j-th channel. That is to say, the sub-audio data of the i-th sub-frequency band of the j-th channel is adapted to the audio characteristics of the i-th sound-emitting unit 110 corresponding to the j-th channel.

### 2. Hardware frequency division processing:

The audio processing module 200 may include a frequency division circuit and perform frequency division processing on the initial audio data through the frequency division circuit. For example, the audio processing module 200 can classify the initial audio data into high-frequency bands, mid-frequency bands, and low-frequency bands through the frequency division circuit. The circuit structure of the frequency division circuit includes a filter circuit composed of capacitors and inductors, for example, a high-pass filter circuit is used to obtain the high-frequency band, a band-pass filter circuit is used to obtain the mid-frequency band, and a lowpass filter is used to obtain the low-frequency band. The specific processing method of hardware frequency division can be the same as the processing method of software frequency division.

For example, multiple channels include a left channel and a right channel. In the case of software frequency division processing and/or hardware frequency division processing, the audio processing module 200 performs frequency division processing on the audio data of each channel through a frequency division circuit and/or an allocation processing algorithm to obtain frequency division data of multiple sub-frequency bands corresponding to the audio data of each channel. Among them, the multiple sub-frequency bands corresponding to the left channel include left channel high frequency, left channel mid frequency, and left channel low frequencies, and the multiple sub-frequency bands corresponding to the right channel include right channel high frequency, right channel mid frequency, and right channel low frequencies.

Further, the audio processing module 200 performs audio adjustment on the corresponding M sub-audio data according to the target audio characteristics of the M sub-audio data respectively to obtain M adjusted audio data, and inputs each adjusted audio data in the M adjusted audio data to the corresponding sound-emitting unit 110 respectively.

In some exemplary embodiments, the target audio characteristics may include volume gain, and audio adjustment is performed on the corresponding M sub-audio data according to the volume gain of the M sub-audio data respectively. For example, the reference volume gain of each frequency point in the predetermined frequency band of the sound-emitting unit 110 corresponding to the target sub-frequency band is obtained, and audio adjustment is performed on the sub-audio data of each frequency point in the target sub-frequency band according to the difference between the volume gain of the sub-audio data of each frequency point in the target sub-frequency band and the reference volume gain of each frequency point in the corresponding predetermined frequency band, so as to reduce the difference between the volume gain of the corresponding frequency point and the reference volume gain. For example, if the volume gain of the sub-audio data at a certain frequency point of the sub-frequency band is greater than the corresponding reference volume gain, the volume gain at that frequency point is reduced; if the volume gain of the sub-audio data at a certain frequency point of the sub-frequency band is less than the corresponding reference volume gain, the volume gain at that frequency point is increased. The reference volume gain may be the volume gain corresponding to the reference audio curve with better sound effect of each pre-set sound-emitting unit.

In some exemplary embodiments, the target audio characteristics may include timbre characteristics, and audio adjustment is performed on the corresponding M sub-audio data according to the timbre characteristics of the M sub-audio data respectively. For example, in some embodiments, the timbre characteristics of the sub-audio data of each frequency point in the target sub-frequency band are determined, and audio adjustment is performed on the sub-audio data of each frequency point in the target sub-frequency band according to the timbre characteristics of each frequency point. For example, if the timbre characteristic includes a human voice characteristic and the target sub-frequency band is a mid-frequency band, the gain of each frequency point in the mid-frequency band is increased to make the human voice more full; if the timbre characteristic includes a guitar characteristic and the target sub-frequency band is a high-frequency band, the gain of each frequency point in the high-frequency band is appropriately increased to enhance the spatial sense of the guitar.

It should be noted that although volume gain or timbre characteristics are taken as examples of target audio characteristics for illustration, a person skilled in the art should understand that the target audio characteristics may also include other appropriate audio characteristics such as pitch, short-time energy, short-time average amplitude, or spectral width, which are also within the scope of the embodiments of this specification.

After the audio processing module 200 performs audio adjustment processing on the sub-audio data of each sub-frequency band to obtain the adjusted audio data corresponding to each sub-frequency band, and the adjusted audio data of each sub-frequency band is adapted to the audio characteristics of the corresponding sound-emitting unit 110, the adjusted audio data corresponding to each sub-frequency band is input to the corresponding sound-emitting unit respectively. For example, the sub-audio data of m sub-frequency bands are respectively input to the corresponding m sound-emitting units 110, and each sound-emitting unit 110 converts the corresponding sub-audio data of the sub-frequency band into target audio to form reverberant sound.

In an exemplary embodiment, the initial audio data includes audio data of K channels, with each channel corresponding to m sound-emitting units 110, or at least two channels corresponding to m sound-emitting units. In the case where each channel corresponds to m sound-emitting units, the audio processing module 200 inputs the sub-audio data of the m sub-frequency bands of each channel in the K channels to the corresponding m sound-emitting units 110 respectively.

In the case where at least two channels correspond to m sound-emitting units, the audio processing module 200 combines the sub-audio data of the sub-frequency bands corresponding to each channel in the at least two channels to obtain integrated audio data, and inputs the integrated audio data of each sub-frequency band to the sound-emitting unit 110 of the corresponding frequency band respectively. For example, suppose that channel k1 and channel k2 both correspond to the same 3 sound-emitting units, the sub-audio data of the 3 sub-frequency bands corresponding to channel k1 is {m11, m12, m13}, and the sub-audio data of the 3 sub-frequency bands corresponding to channel k2 is {m21, m22, m23}. The sub-audio data of the m sub-frequency bands corresponding to channel k1 is combined with the sub-audio data of the m sub-frequency bands corresponding to channel k2 to obtain integrated audio data, namely {(m11+m21), (m12+m22), (m13+m23)}, and the integrated audio data of each sub-frequency band is input to the sound-emitting unit 110 of the corresponding frequency band respectively.

According to the technical solution in the exemplary embodiments of FIG. 2, on the one hand, frequency division processing is performed on the initial audio data to obtain M sub-audio data of corresponding M sub-frequency bands, where each sub-frequency band corresponds to the predetermined frequency band output by one sound-emitting unit among the N sound-emitting units, which can adapt the sub-frequency band where the sub-audio data is located to the working frequency band of the sound-emitting unit, thereby improving the sound quality effect of the audio played by the sound-emitting unit; on the other hand, according to the target audio characteristics of the sub-audio data, audio adjustment is performed on the sub-audio data, and the adjusted audio data is input to the corresponding sound-emitting unit, which can perform audio adjustment on the sub-audio data to be played by the sound-emitting unit according to the audio characteristics of the sub-audio data, so that the audio characteristics of the adjusted audio data of the sub-frequency band are more suitable for the audio characteristics of the corresponding sound-emitting unit, thereby ensuring that the sound emitted by each sound-emitting unit in the sound-emitting module has a better sound-emitting effect, and thus further improving the sound quality effect of the audio played by the sound-emitting unit.

In addition, in some exemplary embodiments, after obtaining the original audio data of one channel, the audio processing module 200 can convert the original audio data of one channel into initial audio data of K channels. A channel can be understood as a channel of audio data, and one channel can correspond to multiple sound-emitting units 110. There can be various ways for the audio processing module 200 to convert the original audio data of one channel into the initial audio data of K channels. For example, the audio processing module 200 can copy the original audio data into initial audio data of K channels and perform frequency division processing on the initial audio data of each channel.

For example, the audio processing module 200 may include a copying circuit to copy the original audio data of one channel into initial audio data of K channels through the copying circuit. In some embodiments, a processor integrated on the audio processing module 200 or an independent processor can also be used to copy the original audio data of a single channel into initial audio data of K channels.

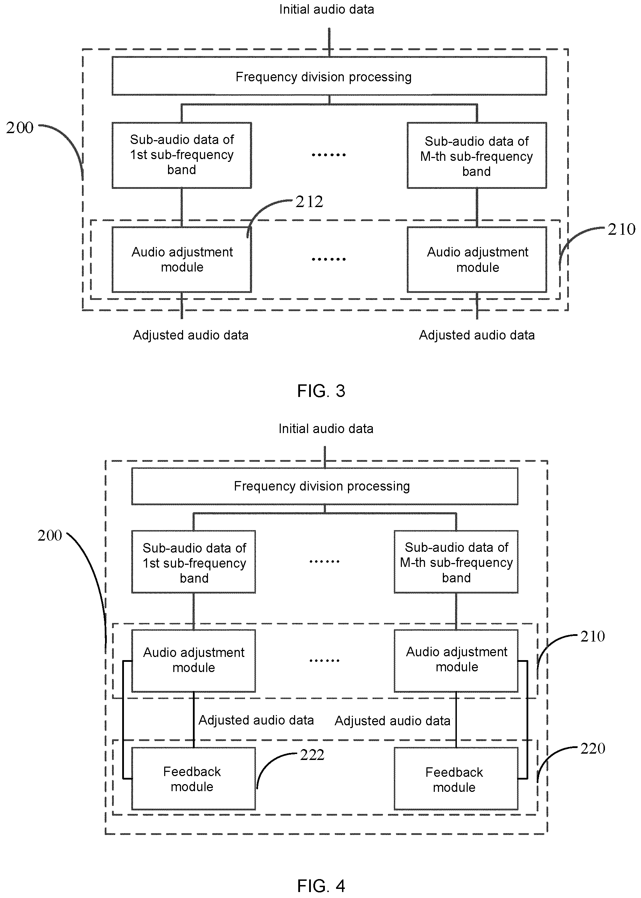

FIG. 3 is a schematic structural diagram of an audio processing module according to some embodiments of this specification.

Referring to FIG. 3, the audio processing module 200 includes an audio adjustment module 210. The audio adjustment module 210 includes multiple audio adjustment modules 212. The multiple audio adjustment modules 212 are configured to: for the sub-audio data of each sub-frequency band in the M sub-frequency bands, perform audio adjustment on the sub-audio data according to the audio adjustment model corresponding to the target audio characteristics of the sub-audio data to obtain M adjusted audio data, where the audio adjustment model corresponds to the sub-frequency band where the sub-audio data is located. The audio adjustment model is an algorithmic model for adjusting the audio characteristics or audio parameters of the sub-audio data of the sub-frequency band.

The audio adjustment module 210 can be of various types, such as a DSP (Digital Signal Processor) circuit or an equalizer circuit.

In some exemplary embodiments, the audio characteristics include volume gain, and the audio adjustment module 212 is configured to: obtain the volume gain of the sub-audio data of the sub-frequency band; determine the audio adjustment model corresponding to the sub-audio data of the sub-frequency band according to the correspondence between the volume gain and the audio adjustment model. For example, the audio adjustment model includes an equalizer adjustment model, i.e., an EQ (Equalizer) algorithm, and the audio adjustment module 212 is configured to: determine the corresponding volume gain according to the audio characteristics of the sub-audio data of the sub-frequency band, determine the equalizer adjustment model corresponding to the sub-audio data of the sub-frequency band according to the corresponding volume gain, and perform audio adjustment processing on the sub-audio data of the sub-frequency band based on the determined equalizer adjustment model.

Furthermore, the volume gain includes multiple volume levels, and different volume levels among the multiple volume levels correspond to different audio adjustment models. The correspondence between volume levels and audio adjustment models is pre-configured. The audio adjustment module 212 is configured to: determine the volume gain of the sub-audio data of the sub-frequency band, determine the volume level corresponding to the sub-audio data according to the volume gain of the sub-audio data, and determine the audio adjustment model corresponding to the sub-audio data of the sub-frequency band according to the correspondence between the volume level and the audio adjustment model. For example, suppose the audio characteristic is volume gain, and different equalizer adjustment models corresponding to different volume levels are pre-set, referring to Table 1 below:

**Table 1. Correspondence between Volume Gain and Audio Adjustment Model**

| Volume Level | Audio Gain Range | Audio Adjustment Model |
|---|---|---|
| 1 | 0-25 dB | 1 |
| 2 | 25-50 dB | 2 |
| 3 | 50-75 dB | 3 |
| 4 | 75-99 dB | 4 |

Referring to Table 1 above, if the volume gain of the sub-audio data is in the range of 25-50 dB, the volume level corresponding to the sub-audio data is determined to be 2. According to the correspondence between the volume level and the audio adjustment model, the audio adjustment model corresponding to the sub-audio data of the sub-frequency band is determined to be audio adjustment model 2, for example, EQ adjustment model 2.

It should be noted that although the audio adjustment model is exemplified by an equalizer adjustment model, a person skilled in the art should understand that the audio adjustment model can also be other appropriate audio algorithm models, such as a Dynamic Range Compression (DRC) model or a sound enhancement model, which are also within the scope of the embodiments of this specification.

In addition, in some exemplary embodiments, the model parameters of the audio adjustment model include equalizer parameters, and the equalizer parameters include gain parameters. The audio adjustment module 212 is configured to: determine the corresponding equalizer parameters according to the audio characteristics of the sub-audio data of the target sub-frequency band, determine the equalizer adjustment model corresponding to the sub-audio data of the target sub-frequency band according to the corresponding equalizer parameters, and perform audio adjustment processing on the sub-audio data of the target sub-frequency band based on the determined audio adjustment model.

For example, the audio adjustment module 212 determines the volume gain of the sub-audio data at the center frequency point of the target sub-frequency band and the reference volume gain at the center frequency point of the predetermined frequency band of the sound-emitting unit 110 corresponding to the target sub-frequency band. Based on the difference between the volume gain of the volume data at the center frequency point of the target sub-frequency band and the reference volume gain, the corresponding equalizer parameters are determined, and the corresponding equalizer model is matched according to the equalizer parameters. For example, if the difference between the volume gain of the volume data at the center frequency point of the target sub-frequency band and the reference volume gain is +10 dB, the equalizer parameter is determined to be +10dB, and the corresponding equalizer model is matched according to this equalizer parameter.

According to the technical solution in the exemplary embodiments of FIG. 3, different audio adjustment models are used for audio adjustment of sub-audio data in different frequency bands, thereby achieving dynamic EQ adjustment for different frequency bands and further improving the sound quality effect of audio played by each sound-emitting unit of the sound-emitting module.

In addition, in some exemplary embodiments, the audio processing module 200 can obtain the volume gain of the current sub-frequency band's sub-audio data in the following two ways. The first way: determine the volume gain of the sub-audio data according to the current sub-frequency band's sub-audio data, for example, determine the average value of the volume gains of the sub-audio data at multiple frequency points in the current sub-frequency band, and use this average value as the absolute volume gain of the current sub-frequency band's sub-audio data. The second way: determine the ratio of the volume gain of the current sub-frequency band's sub-audio data to the volume gains of the sub-audio data of the M sub-frequency bands, and determine the relative volume gain of the current sub-frequency band's sub-audio data according to this ratio, for example, multiply the volume gain of the current sub-frequency band's sub-audio data by this ratio.

According to the technical solution in the above exemplary embodiments, not only the absolute volume gain of the sub-audio data of the currently processed frequency band is considered, but also the volume gain of the audio data of the "overall" frequency band is referenced, and the relative volume gain of the sub-audio data of the current sub-frequency band is determined based on the proportion of the volume gain of the current frequency band in the volume gain of the overall frequency band, thereby reducing the impact of changes in the absolute volume gain of the current sub-frequency band on audio adjustment.

FIG. 4 is a schematic structural diagram of an audio processing module according to some embodiments of this specification.

Referring to FIG. 4, the audio processing module 200 further includes a feedback module 220. The feedback module 220 includes multiple feedback modules 222. The multiple feedback modules 222 are configured to: for each sub-frequency band in the M sub-frequency bands, obtain adjusted audio data of a predetermined time length as sample data; compare the audio data of the sample data with reference audio data, where the reference audio data is the audio data corresponding to the reference audio curve of the audio adjustment model corresponding to the sub-frequency band, and the reference audio curve is an audio curve such as a frequency response curve determined according to the better sound effect output by the sound-emitting unit corresponding to the sub-frequency band; and adjust the model parameters of the audio adjustment model according to the comparison result. For example, the audio adjustment model includes an equalizer adjustment model, and the model parameters include gain parameters.

In some exemplary embodiments, the audio data of the sample data of the sub-frequency band includes the volume gain of each frequency point of the sub-frequency band, and the reference audio data includes the reference volume gain of each frequency point in the corresponding frequency band. The feedback module 222 is configured to: obtain the adjusted audio data of the target sub-frequency band of a predetermined time length as sample data, compare the volume gain of each frequency point of the sample data of the target sub-frequency band with the reference volume gain, and adjust the model parameters of the audio adjustment model according to the comparison result. For example, if the adjusted volume gains of all frequency points are greater than the reference volume gains, it indicates that the adjusted volume gains of all frequency points are relatively large, and the gain parameters of the audio adjustment model need to be reduced; if the adjusted volume gains of all frequency points are less than the reference volume gains, it indicates that the adjusted volume gains of all frequency points are relatively small, and the gain parameters of the audio adjustment model need to be increased.

In some exemplary embodiments, the reference audio data is the audio data corresponding to the reference audio curve of the audio adjustment model corresponding to the sub-frequency band. The audio adjustment model is an equalizer adjustment model, and the reference audio data includes the reference model parameters of the equalizer adjustment model. The model parameters of the corresponding equalizer adjustment model are determined according to the audio data of the sample data. The model parameters in the sample data are compared with the reference model parameters, and the model parameters of the audio adjustment model are adjusted according to the comparison result. For example, if the gain parameter in the sample data is greater than the reference gain parameter, the gain parameter of the audio adjustment model is reduced.

It should be noted that although the model parameters are exemplified by gain parameters, a person skilled in the art should understand that the model parameters may also include other appropriate parameters such as frequency band parameters or bandwidth parameters, which are also within the scope of the embodiments of this specification.

According to the technical solution in the exemplary embodiments of FIG. 4, the sample audio data of each sub-frequency band is compared with the reference audio data, and the model parameters of the audio adjustment model are adjusted according to the comparison result, which can adjust the model parameters of the audio adjustment model according to the difference between the actual sound effect and the reference sound effect of the sound-emitting unit, thereby making the actual sound effect of the sound-emitting unit consistent with the reference sound effect, and further improving the sound quality effect of the audio played by each sound-emitting unit of the sound-emitting module.

Further, in some exemplary embodiments, the audio processing module 200 is also configured to: obtain an update backup corresponding to the reference audio data of the audio adjustment model, and update the reference audio data of the audio adjustment model according to the update backup. The reference audio data is the audio data corresponding to the reference audio curve of the audio adjustment model corresponding to the sub-frequency band. For example, the reference audio data corresponding to the reference audio curves of the audio adjustment models for various sound effects are pre-set. When updating the reference audio data of a target sound effect, an update backup corresponding to the reference audio data of the audio adjustment model for the target sound effect is obtained, and the reference audio data is updated according to the update backup. There can be various types of target sound effects, such as heavy metal, light music, electronic music, classical, pop music, or jazz. The audio processing device includes a memory in which a backup area for reference audio data is set. In response to an update request for a target sound effect initiated by a terminal device, an update backup of the reference audio data of the audio adjustment model for the target sound effect is obtained via wireless transmission, such as Bluetooth, through OTA (Over-the-Air Technology), and the obtained update backup of the reference audio data for the target sound effect is stored in the backup area. The reference audio data corresponding to the target sound effect is updated according to the update backup corresponding to the target reference sound effect in the backup area.

According to the technical solution in the above exemplary embodiments, by obtaining an update backup of the reference audio data corresponding to the target sound effect and updating the reference audio data of the target sound effect, the original target sound effect can be updated with a target sound effect of better sound quality, thereby improving or changing the sound quality effect of the target sound effect.

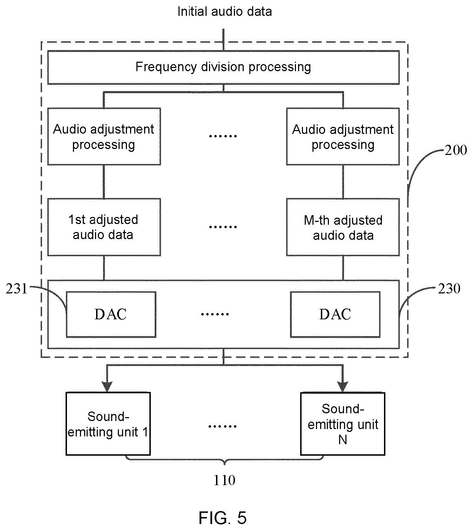

In addition, as shown in FIG. 5, the audio processing module 200 may further include a DAC (Digital to Analog Converter) module 230. The DAC module 230 may include at least one DAC 231. The audio processing module 200 can input the adjusted audio data of the m sub-frequency bands of each channel of the K channels to the corresponding m sound-emitting units 110 respectively through the DAC 231 in the DAC module. When working, the DAC module 230 receives the adjusted audio data of the K channels, converts the adjusted audio data of the K channels into K analog electrical signals, and inputs the K analog electrical signals to the corresponding sound-emitting units 110 respectively. The correspondence between the DAC 231 in the DAC module 230 and the K sound-emitting units can be various, such as one-to-one, one-to-many, or many-to-many, and so on.

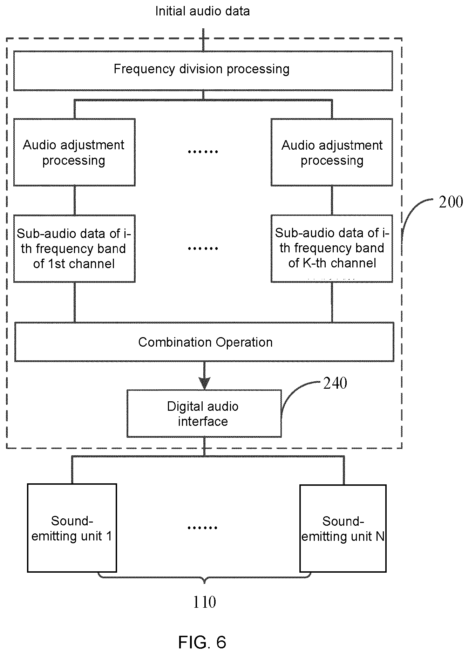

As shown in FIG. 6, the audio processing module 200 can combine the sub-audio data of the same sub-frequency band from at least two channels into an audio data frame through a combination operation, thereby obtaining integrated audio data.

The integrated audio data includes at least two sub-audio data of the same sub-frequency band. For example, the integrated audio data includes the sub-audio data of the i-th sub-frequency band of the first channel and the K-th channel, where i is any integer in [1, m]. Through the i-th identifier, the audio data to be played corresponding to the i-th sub-frequency band can be identified in the integrated audio data. The digital audio interface 240 or the i-th sound-emitting unit 110 can identify the audio data to be played by the i-th sound-emitting unit based on the i-th identifier.

After combining the sub-audio data of the same sub-frequency band from at least two channels, the audio processing module 200 can input the combined integrated audio data to the corresponding sound-emitting units 110 respectively. Since the integrated audio data is still digital audio data at this time, the audio processing module 200 may further include a digital audio interface 240, as shown in FIG. 6. During operation, the audio processing module 200 can input the integrated audio data to the N sound-emitting units of the corresponding frequency bands respectively through the digital audio interface 240.

There can be various ways for the audio processing module 200 to input the integrated audio data to the corresponding N sound-emitting units through the digital audio interface 240. For example, after receiving the integrated audio data, the digital audio interface 240 directly sends the integrated audio data to the corresponding N sound-emitting units 110 respectively, and the N sound-emitting units 110 identify the corresponding audio data to be played in the integrated audio data; or, the digital audio interface 240 identifies the audio data to be played corresponding to each sound-emitting unit 110 in the integrated audio data and sends the audio data to be played to the corresponding sound-emitting unit 110.

Digital Audio Interfaces (DAI) 240 can be understood as interfaces for transmitting digital audio signals at the board level or between boards. Compared to analog interfaces, digital audio interfaces 240 have stronger anti-interference capabilities and simpler hardware design. There can be various types of digital audio interfaces 240, such as at least one of I2S (an Inter-IC Sound interface), TDM (Time Division Multiplexing), PCM (Pulse Code Modulation), and PDM (Pulse Density Modulation). When the digital audio interface 240 identifies the target audio data corresponding to each sound-emitting unit 110 in the integrated audio data and sends the target audio data to the corresponding sound-emitting unit 110, the digital audio interface 240 needs to have the ability to identify the target audio data corresponding to each sound-emitting unit 110. Therefore, the digital audio interface 240 at this time is a digital audio interface 240 with identification and distribution functions. When working, the digital audio interface 240 receives the integrated audio data, identifies the identifier of the sub-frequency band corresponding to each sound-emitting unit 110 and the audio data to be played corresponding to this identifier in the integrated audio data, and sends the audio data to be played to the corresponding sound-emitting unit 110.

After receiving the corresponding audio data to be played, the N sound-emitting units can play the audio data to form reverberant sound. For example, the sound-emitting unit 110 sends the audio to be played to at least one speaker, and the at least one speaker plays the audio to be played. By playing the corresponding target audio through the speakers in the N sound-emitting units 110, reverberant sound can be formed.

When the N sound-emitting units 110 are working, they can simultaneously play the corresponding target audio using the same phase, which can avoid mutual interference between different target audio in the reverberant sound, thereby affecting the sound quality of the reverberant sound.

The N sound-emitting units include at least high-frequency, mid-frequency, and low-frequency speakers. The high-frequency, mid-frequency, and low-frequency ranges can be set according to the actual spectrum of the initial audio data. The spectrum of the initial audio data includes K frequency bands, and these K frequency bands can cover the high, mid, and low frequency ranges. As mentioned earlier, in some application scenarios, low frequency can generally refer to the frequency band from 20 Hz to 150 Hz, mid frequency can generally refer to the frequency band from 150 Hz to 5K Hz, high frequency can generally refer to the frequency band from 5K Hz to 20K Hz, mid-low frequency can generally refer to the frequency band from 150 Hz to 500 Hz, and mid-high frequencies can refer to the frequency band from 500 Hz to 5K Hz. A person skilled in the art will understand that the above distinction of frequency bands is given as an example to roughly indicate the intervals. The definition of the above frequency bands can change with different industries, different application scenarios, and different classification standards. For example, in some other application scenarios, low frequency refers to the frequency band from approximately 20 Hz to 80 Hz, mid-low frequency can refer to the frequency band between approximately 80 Hz and 160 Hz, mid frequency can refer to the frequency band from approximately 160 Hz to 1280 Hz, mid-high frequencies can refer to the frequency band from approximately 1280 Hz to 2560 Hz, and high frequency can refer to the frequency band from approximately 2560 Hz to 20K Hz.

There can be various types of speakers, such as air speakers and vibration conduction speakers, and so on. The air speaker can be understood as a speaker that outputs air-conducted sound waves, while the vibration speaker can be understood as a speaker that outputs sound waves conducted through a solid medium (such as bone-conducted sound waves). The vibration speaker and the air conduction speaker can be two independent functional devices or part of a single device that achieves multiple functions. Each sound-emitting unit 110 in the N sound-emitting units 110 may include at least one of an air speaker and a vibration speaker.

In some embodiments, the audio processing device 10 can be a headset. There can be various types of headsets, such as wired headsets, wireless headsets, or Bluetooth headsets, and so on.

In some embodiments, the audio processing device 10 may also include an audio playback device that performs audio processing, such as a hearing aid, a speaker, or other audio playback devices, and so on.

In some embodiments, the correspondence between channels and sound-emitting units 110 may include at least one of a many-to-one relationship and a one-to-many relationship. The aforementioned many-to-one relationship refers to multiple channels corresponding to the same sound-emitting unit 110. For example, if there are K channels and N sound-emitting units, at least two channels correspond to the same sound-emitting unit 110, such that the audio processing module 200 or the processor 400 sends the adjusted audio data of the K channels to the N sound-emitting units 110. The aforementioned one-to-many relationship refers to one channel corresponding to multiple sound-emitting units 110. For example, if there are K channels and N sound-emitting units, the m sub-frequency bands of one channel correspond to m sound-emitting units, where N=m*K, such that the audio processing module 200 or the processor 400 sends the adjusted audio data of the K channels to the N sound-emitting units 110.

In some embodiments, when at least one sound-emitting unit 110 among the N sound-emitting units 110 changes or when an sound effect adjustment request is received, the audio processing module 200 can adjust the correspondence between the target audio characteristics and the audio adjustment model. There can be various situations in which a sound-emitting unit 110 changes, such as a sound-emitting unit failing to emit sound, a sound-emitting unit malfunctioning, or a change in the sound-emitting performance of a sound-emitting unit (for example, a sound-emitting unit changing from bone conduction to air conduction), or other changes, and so on. The aforementioned sound effect adjustment request can be a request to adjust the sound effect of the currently playing audio. The sound effect can be the playback effect of the currently playing audio, and there can be various types of sound effects, such as heavy metal, light music, electronic music, classical music, pop music, or jazz, and so on. When at least one sound-emitting unit 110 among the N sound-emitting units 110 changes in sound emission or when a sound effect adjustment request is received, either the audio processing module 200 or the processor 400 can adjust the correspondence between the target audio characteristics and the audio adjustment model.

For example, the correspondence between target audio characteristics and audio adjustment models under different sound effects is pre-set. When a sound effect adjustment request is received, the correspondence between target audio characteristics and audio adjustment models under the target sound effect is obtained according to the identifier of the target sound effect.

In the above description, the audio processing module 200 in the audio processing device 10 and other electronic devices cooperating with it, such as DACs and spectrum adjustment devices, can all be circuits or electronic devices integrated on one or more circuit boards electrically connected to each other. The audio processing device 10 may also include a processor and a storage medium, and then the processor is used to complete all or part of the functions of the audio processing module 200 and some electronic devices.

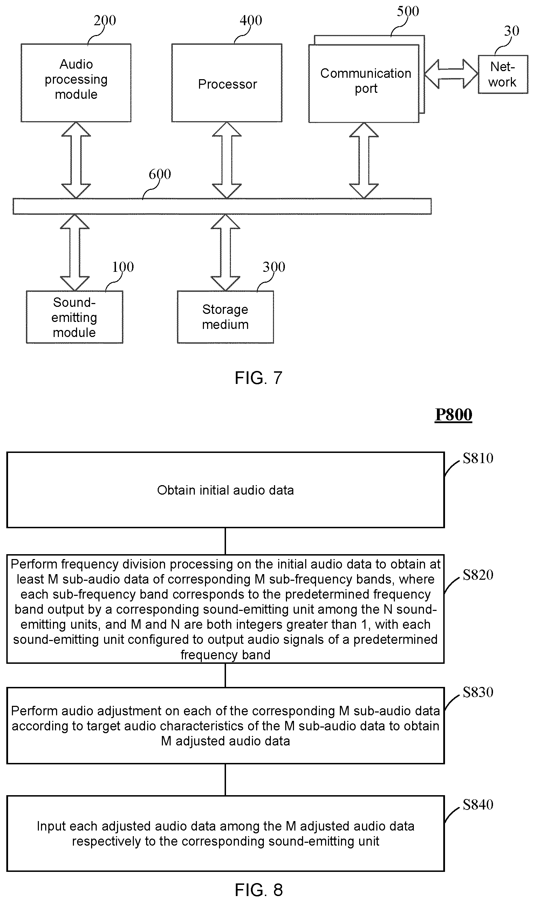

FIG. 7 is a schematic structural diagram of an audio processing device according to some embodiments of this specification.

Referring to FIG. 7, in addition to the hardware described earlier, such as the audio processing module 200 and the sound-emitting module, the audio processing device 10 may also include at least one storage medium 300 and at least one processor 400. To meet internal and external communication needs, the audio processing device 10 may also include a communication port 500 and an internal communication bus 600.

The internal communication bus 600 can connect different system components, including the storage medium 300, the processor 400, and the communication port 500.

The audio processing device 10 can complete data communication with the outside world through the communication port 500. For example, the audio processing device 10 can obtain initial audio data from the target device 20 through the communication port 500.

The at least one storage medium 300 may include a data storage device. The data storage device may be a non-transitory storage medium or a transitory storage medium. For example, the data storage device may include one or more of a magnetic disk, a read-only storage medium (ROM), or a random-access storage medium (RAM). When the audio processing device 10 is running, the storage medium 300 may also include at least one instruction set stored in the data storage device for obtaining initial audio data and processing the initial audio data. The instructions are computer program code, and the computer program code may include programs, routines, objects, components, data structures, procedures, modules, etc., for executing the audio processing method provided in this specification.

The at least one processor 400 can be communicatively connected to the at least one storage medium 300 through the internal communication bus 600. The communication connection refers to any form of connection that can directly or indirectly receive information. The at least one processor 400 is used to execute the aforementioned at least one instruction set. When the audio processing device 10 is running, the at least one processor 400 reads the at least one instruction set and executes the audio processing method provided in this specification according to the instructions of the at least one instruction set. The processor 400 can execute all steps included in the audio processing method. The processor 400 can be in the form of one or more processors. In some embodiments, the processor 400 can include one or more hardware processors, such as a microcontroller, a microprocessor, a reduced instruction set computer (RISC), an application-specific integrated circuit (ASIC), an application-specific instruction set processor (ASIP), a central processing unit (CPU), a graphics processing unit (GPU), a physics processing unit (PPU), a microcontroller unit, a digital signal processor (DSP), a field-programmable gate array (FPGA), an Advanced RISC Machine (ARM), a programmable logic device (PLD), any circuit or processor capable of performing one or more functions, or any combination thereof. For illustrative purposes only, only one processor 400 is described in the audio processing device 10 in this specification. However, it should be noted that the audio processing device 10 in this specification can also include multiple processors 400. Therefore, the operations and/or method steps disclosed in this specification can be performed by one processor as described in this specification, or can be jointly performed by multiple processors. For example, if the processor 400 of the audio processing device 10 in this specification executes step A and step B, it should be understood that step A and step B can also be jointly or separately executed by two different processors 400 (for example, the first processor executes step A, the second processor executes step B, or the first and second processors jointly execute steps A and B).

In some embodiments, when the audio processing device 10 processes the initial audio data, all audio processing steps can be performed by the audio processing module 200, or they can be jointly completed by the audio processing module 200, the storage medium 300, and the processor 400.

There can be various ways in which the audio processing module 200 executes all audio processing steps. For example, the audio processing module 200 obtains the initial audio data; performs frequency division processing on the initial audio data to obtain at least M sub-audio data of corresponding M sub-frequency bands, where each sub-frequency band corresponds to the predetermined frequency band output by the corresponding sound-emitting unit among the N sound-emitting units, and M is an integer greater than 1; performs audio adjustment on each of the corresponding M sub-audio data according to the target audio characteristics of the M sub-audio data to obtain M adjusted audio data; and inputs each adjusted audio data in the M adjusted audio data to the corresponding sound-emitting unit to form reverberant sound.

There can be various ways in which the audio processing module 200, the storage medium 300, and the processor 400 jointly complete the audio processing steps. For example, the audio processing module 200 or the processor 400 obtains the initial audio data. The processor 400 retrieves control instructions from the storage medium 300 to perform frequency division processing on the initial audio data, obtaining at least M sub-audio data of corresponding M sub-frequency bands. Based on the target audio characteristics of the M sub-audio data, the processor 400 performs audio adjustment on each of the corresponding M sub-audio data to obtain M adjusted audio data. The processor 400 sends the M adjusted audio data to the DAC module 230 in the audio processing module 200. After receiving the M adjusted audio data, the DAC module 230 converts the M adjusted audio data into analog electrical signals and sends the analog electrical signals to the corresponding sound-emitting units 100. Each sound-emitting unit converts the corresponding adjusted audio data into target audio to form reverberant sound. Alternatively, the audio processing module 200 or the processor 400 obtains the initial audio data. The processor 400 retrieves control instructions from the storage medium 300 and performs frequency division processing on the initial audio data based on these instructions, obtaining at least M sub-audio data of corresponding M sub-frequency bands. Based on the target audio characteristics of the M sub-audio data, the processor 400 performs audio adjustment on each of the corresponding M sub-audio data to obtain M adjusted audio data. The processor 400 performs a combination operation on the adjusted audio data of at least two channels to obtain integrated audio data and sends the integrated audio data to the digital audio interface 240 in the audio processing module 200. The digital audio interface 240 sends the integrated audio data to the corresponding sound-emitting units 110. The sound-emitting units 110 identify the corresponding adjusted audio data in the integrated audio data and convert the adjusted audio data into target audio to form reverberant sound, and so on.

Below, the audio processing method in the exemplary embodiments of this specification will be described in detail with reference to the accompanying drawings.

FIG. 8 is a schematic flowchart of an audio processing method for an audio processing device according to some embodiments of this specification. **The** audio processing device 10 can execute the audio processing method P800 of this specification. Specifically, the audio processing module 200 and/or the processor 400 in the audio processing device 10 can read the instruction set stored in the local storage medium, and then, according to the instructions of the instruction set, execute the audio processing method P800 described in this specification. As shown in FIG. 8, the method P800 may include: steps S810 to S840. Below, the audio processing method of the embodiments of this specification will be described in detail with reference to FIG. 8.

Referring to FIG. 8, in step S810, obtain initial audio data.

For example, the audio processing module 200 or the processor 400 can obtain initial audio data. The ways to obtain initial audio data can be found in the description above, and will not be repeated herein.

In step S820, perform frequency division processing on the initial audio data to obtain at least M sub-audio data of corresponding M sub-frequency bands, where each sub-frequency band corresponds to the predetermined frequency band output by a corresponding sound-emitting unit among the N sound-emitting units, and M and N are both integers greater than 1, with each sound-emitting unit configured to output audio signals of a predetermined frequency band.

In some exemplary embodiments, frequency division processing can be performed on the initial audio data by software or by hardware. For example, the audio processing module 200 or the processor 400 can use a frequency division processing algorithm to perform frequency division processing on the initial audio data of K channels to obtain m sub-audio data of m sub-frequency bands for each channel, where M=K*m, and K is an integer greater than or equal to 1. For instance, if the initial audio data has 2 channels and there are 4 sound-emitting units, with each channel corresponding to 2 sound-emitting units and 2 sub-frequency bands, then M=N=4, K=2, and m=2.

Taking the case where the sound-emitting unit 110 includes a bone conduction sound-emitting unit and an air conduction sound-emitting unit as an example, the bone conduction sound-emitting unit has a better sound effect for mid- and high-frequency audio data. Therefore, the predetermined frequency band, i.e., the working frequency band, corresponding to the bone conduction sound-emitting unit is the mid-high frequency band(s). On the other hand, the air conduction sound-emitting unit has a better sound emission effect for low-frequency audio data. Therefore, the predetermined frequency band, i.e., the working frequency band, corresponding to the air conduction sound-emitting unit is the low-frequency band. For the specific content of frequency division processing, please refer to the description above, which will not be repeated herein.

In step S830, perform audio adjustment on each of the corresponding M sub-audio data according to target audio characteristics of the M sub-audio data to obtain M adjusted audio data.

In exemplary embodiments, the target audio characteristic may include volume gain, and audio adjustment is performed on each of the corresponding M sub-audio data according to the volume gain of the M sub-audio data. For example, the audio processing module 200 or the processor 400 obtains the reference volume gain of each frequency point in the predetermined frequency band of the sound-emitting unit 110 corresponding to the target sub-frequency band. Based on the difference between the volume gain of the sub-audio data at each frequency point of the target sub-frequency band and the reference volume gain at each frequency point of the corresponding predetermined frequency band, audio adjustment is performed on the sub-audio data at each frequency point of the target sub-frequency band to reduce the difference between the volume gain and the reference volume gain at the corresponding frequency point. For instance, if the volume gain of the sub-audio data at a certain frequency point of the sub-frequency band is greater than the corresponding reference volume gain, the volume gain at that frequency point is decreased; if the volume gain of the sub-audio data at a certain frequency point of the sub-frequency band is less than the corresponding reference volume gain, the volume gain at that frequency point is increased. For the specific details of the audio adjustment in step S830, please refer to the description above, which will not be repeated herein.

In step S840, input each adjusted audio data among the M adjusted audio data respectively to the corresponding sound-emitting unit.

In some exemplary embodiments, the initial audio data includes audio data of K channels, with each channel corresponding to m sound-emitting units 110, or at least two channels corresponding to m sound-emitting units, where M=K*m, and K is an integer greater than or equal to 1. For example, if the initial audio data has 2 channels and there are 4 sound-emitting units, with each channel corresponding to 2 sound-emitting units and 2 sub-frequency bands, then M=N=4, K=2, and m=2. In the case where each channel corresponds to m sound-emitting units, the audio processing module 200 inputs the sub-audio data of the m sub-frequency bands of each channel in the K channels to the corresponding m sound-emitting units 110 respectively. For the specific details of step S840, please refer to the description above, which will not be repeated herein.

According to the technical solution in the exemplary embodiments of FIG. 8, on the one hand, frequency division processing is performed on the initial audio data to obtain M sub-frequency band sub-audio data corresponding to the M sub-frequency bands, and each sub-frequency band corresponds to a predetermined frequency band output by one sound-emitting unit among the N sound-emitting units, which can adapt the sub-frequency band where the sub-audio data is located to the working frequency band of the sound-emitting unit, thereby improving the sound quality effect of the audio played by the sound-emitting unit; on the other hand, according to the target audio characteristics of the sub-audio data, audio adjustment is performed on the sub-audio data, and the adjusted audio data is input to the corresponding sound-emitting unit, which can perform audio adjustment on the sub-audio data to be played by the sound-emitting unit according to the audio characteristics of the sub-audio data, so that the audio characteristics of the adjusted audio data of the sub-frequency band are more adapted to the audio characteristics of the corresponding sound-emitting unit, thereby ensuring that the sound emitted by each sound-emitting unit in the sound-emitting module has a better sound-emitting effect, and thus can further improve the sound quality effect of the audio played by the sound-emitting unit.

In some embodiments, based on the above solutions, the aforementioned performing audio adjustment on the corresponding M sub-audio data respectively includes, for each of the aforementioned sub-audio data:
Performing the aforementioned audio adjustment on the aforementioned sub-audio data according to the audio adjustment model corresponding to the target audio characteristics of the aforementioned sub-audio data, where the aforementioned audio adjustment model corresponds to the sub-frequency band where the aforementioned sub-audio data is located.

In some embodiments, based on the above scheme, the aforementioned target audio characteristics include volume gain, and before performing the aforementioned audio adjustment on the aforementioned sub-audio data, the aforementioned method further includes:
Obtaining the volume gain of the sub-audio data of the aforementioned sub-frequency band;
Determining the audio adjustment model corresponding to the sub-audio data of the aforementioned sub-frequency band according to the correspondence between the aforementioned volume gain and the aforementioned audio adjustment model.

In some embodiments, based on the above scheme, the aforementioned volume gain includes multiple volume levels, and different volume levels among the aforementioned multiple volume levels correspond to different audio adjustment models.

In some embodiments, based on the above scheme, the aforementioned method further includes, for each sub-frequency band among the aforementioned M sub-frequency bands:
Obtaining adjusted audio data of a predetermined time length as sample data;
Comparing the audio data of the aforementioned sample data with reference audio data, where the aforementioned reference audio data is the audio data corresponding to the reference audio curve of the aforementioned audio adjustment model corresponding to the aforementioned sub-frequency band;
Adjusting the model parameters of the aforementioned audio adjustment model according to the comparison result.

In some embodiments, based on the above scheme, the aforementioned audio processing module is further configured to:
Obtain an updated backup corresponding to the aforementioned reference audio data, and update the aforementioned reference audio data according to the aforementioned updated backup.

In some embodiments, based on the above scheme, the aforementioned audio adjustment model is an equalizer adjustment model, and the aforementioned model parameters are equalizer parameters.

In some embodiments, based on the above scheme, the aforementioned N sound-emitting units include a bone conduction sound-emitting unit and an air conduction sound-emitting unit, where the aforementioned bone conduction sound-emitting unit outputs mid-high frequency audio signals during operation, and the aforementioned air conduction sound-emitting unit outputs low-frequency audio signals during operation.

In some embodiments, based on the above scheme, the aforementioned initial audio data includes audio data of K channels, and the frequency band interval of each channel includes m sub-frequency bands, where m=M/K, and K is an integer greater than or equal to 1.

In some embodiments, based on the above scheme, the aforementioned K channels include a left channel and a right channel, the m sub-frequency bands corresponding to the aforementioned left channel include the mid-high frequencies of the left channel and the low frequencies of the left channel, and the m sub-frequency bands corresponding to the aforementioned right channel include the mid-high frequencies of the right channel and the low frequencies of the right channel.

In some embodiments, based on the above scheme, the correspondence between the aforementioned channels and the aforementioned sound-emitting units includes at least one of a one-to-many relationship and a many-to-one relationship.

In some embodiments, based on the above scheme, the aforementioned audio processing device can be headphones, and of course, the aforementioned audio processing device can also be other electronic devices, such as sound-emitting devices on head-mounted VR devices, stereo sound equipment in cinemas, and so on.

The above are schematic solutions of the audio processing method according to some embodiments of this specification. It should be noted that the technical solution of this audio processing method belongs to the same concept as the technical solution of the aforementioned audio processing device, and for the details not described in detail in the technical solution of the audio processing method, reference can be made to the description of the technical solution of the aforementioned audio processing device.

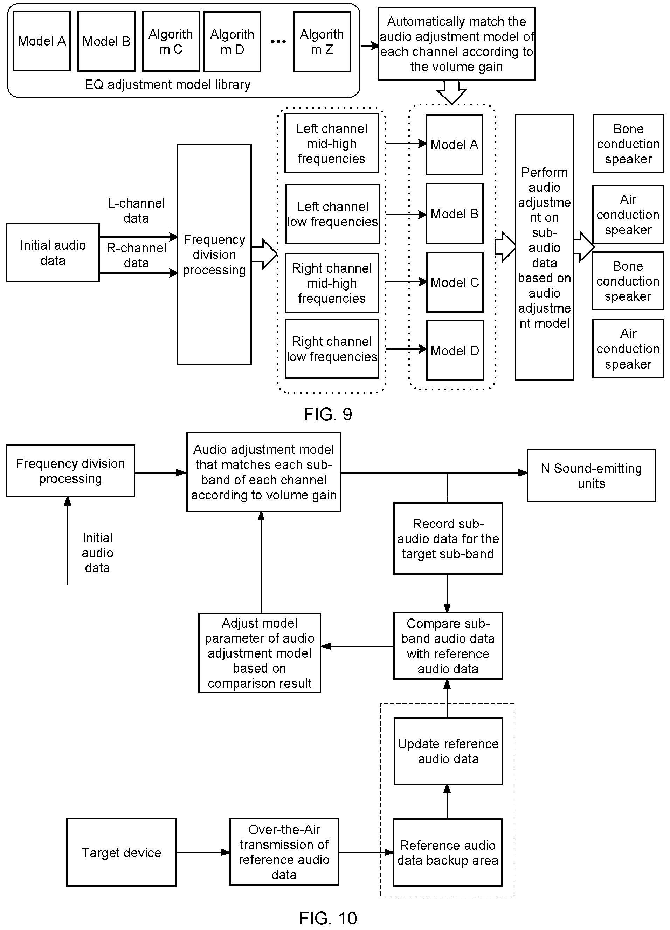

FIG. 9 is a schematic flowchart of another audio processing method provided according to some embodiments of this specification.

Referring to FIG. 9, initial audio data undergoes frequency division processing to obtain sub-audio data for multiple sub-frequency bands. For example, if the initial audio data is stereo data, which includes left channel data and right channel data, frequency division processing is performed on the left channel data and the right channel data to obtain left channel mid-high frequency data, left channel low-frequency data, right channel mid-high frequency data, and right channel low-frequency data. Based on the audio gain of the sub-audio data of each sub-frequency band, a corresponding audio adjustment model is matched from the audio adjustment model library. For example, the volume level of the audio gain of the sub-audio data is determined, and based on the pre-set correspondence between the volume level and the audio adjustment model, the audio adjustment model corresponding to the sub-audio data is determined from the audio adjustment model library. For example, the volume of the first volume level is the output level of the original audio signal after passing through a power amplifier, with a gain of 0 dB, and each decrease in level reduces it by 3 dB, with the minimum volume level being -99 dB gain, totaling 16 volume levels), and several audio adjustment models in the audio adjustment library are automatically matched with the volume level of the sub-audio data. Audio adjustment is performed on the corresponding sub-audio data based on the matched audio adjustment model to obtain the corresponding adjusted audio data.

Referring to FIG. 9, the volume levels of the left channel mid-high frequency data, left channel low-frequency data, right channel mid-high frequency data, and right channel low-frequency data are determined, and according to the determined volume levels, four pre-set EQ adjustment models are selected from the EQ adjustment model library and respectively configured to the corresponding audio paths. Audio adjustment is performed on the left channel mid-high frequency data according to EQ adjustment model A; audio adjustment is performed on the left channel low frequencies according to EQ adjustment model B; audio adjustment is performed on the right channel mid-high frequencies according to EQ adjustment model C; and audio adjustment is performed on the right channel low frequencies according to EQ adjustment model D.

Moreover, referring to FIG. 9, the initial audio data has 2 channels, namely the left channel and the right channel, and there are 4 sound-emitting units. Each channel corresponds to 2 sound-emitting units and 2 sub-frequency bands. Thus, M=N=4, K=2, and m=2. Among these, the 2 sub-frequency bands corresponding to the left channel include the left channel mid-high frequencies and the left channel low frequencies, and the 2 sub-frequency bands corresponding to the right channel include the right channel mid-high frequencies and the right channel low frequencies. The left channel corresponds to one bone conduction speaker and one air conduction speaker; the right channel corresponds to one bone conduction speaker and one air conduction speaker. The bone conduction speaker outputs mid-high frequency audio signals during operation, and the air conduction speaker outputs low-frequency audio signals during operation. When each channel corresponds to 2 sound-emitting units, the audio processing module 200 inputs the adjusted audio data of the 2 sub-frequency bands of each of the 2 channels to the corresponding 2 sound-emitting units 110, respectively. The specific process can be referred to the description above, and will not be repeated herein.

FIG. 10 is a schematic flowchart of a method for adjusting model parameters of an audio adjustment model according to some embodiments of this specification.

Referring to FIG. 10, initial audio data undergoes frequency division processing to obtain sub-audio data for multiple sub-frequency bands. Based on the audio gain of the sub-audio data of each sub-frequency band, a corresponding audio adjustment model is matched from the audio adjustment model library. For example, the volume level of the audio gain of the sub-audio data of the sub-frequency band is determined, and based on the pre-set correspondence between the volume level and the audio adjustment model, the audio adjustment model corresponding to the sub-audio data is determined from the audio adjustment model library.

Further, for each sub-frequency band among the M sub-frequency bands, adjusted audio data of a predetermined time length is obtained as sample data. For example, referring to FIG. 10, a segment of sub-audio data is recorded as sample data for the target sub-frequency band; the audio data of the sample data is compared with reference audio data, where the reference audio data is the audio data corresponding to the reference audio curve of the audio adjustment model corresponding to the sub-frequency band, and the reference audio curve is an audio curve (such as a frequency response curve) determined by acoustics professionals based on the better sound effect output by the sound-emitting unit corresponding to the sub-frequency band; the model parameters of the audio adjustment model are adjusted according to the comparison result. For example, the audio adjustment model includes an equalizer model, and the model parameters include gain parameters. The specific process can be referred to the description above and will not be repeated herein.

Moreover, referring to FIG. 10, an updated backup corresponding to the reference audio data of the audio adjustment model is obtained from the target device, and the reference audio data of the audio adjustment model is updated according to the updated backup. For example, reference audio data corresponding to the reference audio curves of audio adjustment models for various sound effects are pre-set. When updating the reference audio data of a target sound effect, an updated backup corresponding to the reference audio data of the audio adjustment model for the target sound effect is obtained, and the reference audio data is updated according to the updated backup. There can be various types of target sound effects, such as heavy metal, light music, electronic music, classical, pop music, or jazz. The audio processing device includes a memory, in which a backup area for reference audio data is set. In response to an update request for a target sound effect initiated by the target device, an updated backup of the reference audio data of the audio adjustment model for the target sound effect is obtained via wireless transmission, such as Bluetooth, through OTA (Over-the-Air Technology), and the obtained updated backup of the reference audio data for the target sound effect is stored in the backup area. The reference audio data corresponding to the target reference sound effect is updated according to the updated backup corresponding to the target reference sound effect in the backup area.

In summary, the audio processing device and audio processing method provided in this specification include a sound-emitting module and an audio processing module. The sound-emitting module includes N sound-emitting units, each of which outputs an audio signal of a predetermined frequency band during operation. After obtaining initial audio data, the audio processing module performs frequency division processing on the initial audio data to obtain at least M sub-audio data corresponding to M sub-frequency bands. Each sub-frequency band corresponds to the predetermined frequency band output by a corresponding sound-emitting unit among the N sound-emitting units. The audio processing module performs audio adjustment on each of the corresponding M sub-audio data according to the target audio characteristics of the M sub-audio data to obtain M adjusted audio data, and inputs each adjusted audio data to the corresponding sound-emitting unit. On the one hand, by performing frequency division processing on the initial audio data to obtain the corresponding M sub-frequency band sub-audio data, where each sub-frequency band corresponds to the predetermined frequency band output by one sound-emitting unit among the N sound-emitting units, the sub-frequency band where the sub-audio data is located can be adapted to the working frequency band of the sound-emitting unit, thereby improving the sound quality effect of the audio played by the sound-emitting unit. On the other hand, by performing audio adjustment on the sub-audio data according to the target audio characteristics of the sub-audio data and inputting the adjusted audio data to the corresponding sound-emitting unit, audio adjustment can be performed on the sub-audio data to be played by the sound-emitting unit according to the audio characteristics of the sub-audio data, thereby making the audio characteristics of the adjusted audio data of different frequency bands more suitable for the audio characteristics of the corresponding sound-emitting units, and further ensuring that the sound emitted by each sound-emitting unit in the sound-emitting module has a better sound-emitting effect, thus further improving the sound quality effect of the audio played by the sound-emitting unit.

This specification, on the other hand, provides a non-transitory storage medium storing at least one set of executable instructions for performing audio processing. When the executable instructions are executed by a processor, the executable instructions direct the processor to implement the steps of the audio processing method P800 described in this specification. In some possible implementations, various aspects of this specification may also be implemented in the form of a program product, which includes program code. When the program product runs on the audio processing device 10, the program code is used to make the audio processing device 10 execute the steps of the audio processing method P800 described in this specification. The program product for implementing the above method may use a portable compact disc read-only memory (CD-ROM) that includes program code and can run on the audio processing device 10. However, the program product of this specification is not limited to this. In this specification, the readable storage medium can be any tangible medium that contains or stores a program, which can be used by or in combination with an instruction execution system. The program product may adopt any combination of one or more readable media. The readable medium may be a readable signal medium or a readable storage medium. The readable storage medium may be, for example, but not limited to, an electrical, magnetic, optical, electromagnetic, infrared, or semiconductor system, apparatus, or device, or any combination of the above. More specific examples of readable storage media include: an electrical connection with one or more conductors, a portable disk, a hard disk, random access memory (RAM), read-only memory (ROM), erasable programmable read-only memory (EPROM or flash memory), optical fiber, portable compact disc read-only memory (CD-ROM), optical storage device, magnetic storage device, or any suitable combination of the above. The computer-readable storage medium may include a data signal propagated in baseband or as part of a carrier wave, which carries readable program code. Such propagated data signals may take various forms, including but not limited to electromagnetic signals, optical signals, or any suitable combination of the above. The readable storage medium may also be any readable medium other than a readable storage medium, which can send, propagate, or transmit a program for use by or in combination with an instruction execution system, apparatus, or device. The program code contained on the readable storage medium can be transmitted using any suitable medium, including but not limited to wireless, wired, optical cable, RF, etc., or any suitable combination of the above. The program code for performing the operations of this specification can be written in any combination of one or more programming languages, including object-oriented programming languages-such as Java, C++, etc., and also including conventional procedural programming languages, such as the "C" language or similar programming languages. The program code may be executed entirely on the audio processing device 10, partly on the audio processing device 10, as a standalone software package, partly on the audio processing device 10 and partly on a remote computing device, or entirely on a remote computing device.

The above describes some embodiments in this specification. Other embodiments are within the scope of the appended claims. In some cases, the actions or steps recited in the claims may be performed in an order different from that in the embodiments and still achieve the desired results. Additionally, the processes depicted in the drawings do not necessarily require the specific order or sequential order shown to achieve the desired results. In certain implementations, multitasking and parallel processing are also possible or may be advantageous.

In summary, after reading this detailed disclosure, a person skilled in the art will understand that the foregoing detailed disclosure may be presented by way of example only and may not be limiting. Although not explicitly stated herein, a person skilled in the art will understand that this specification is intended to encompass various reasonable changes, improvements, and modifications to the embodiments. These changes, improvements, and modifications are intended to be proposed by this specification and are within the spirit and scope of the exemplary embodiments of this specification.

Moreover, certain terms in this specification have been used to describe embodiments of this specification. For example, "an embodiment," "one embodiment," and/or "some embodiments" mean that a particular feature, structure, or characteristic described in connection with the embodiment may be included in at least one embodiment of this specification. Therefore, it may be emphasized and should be understood that two or more references to "an embodiment" or "one embodiment" or "alternative embodiment" in various parts of this specification do not necessarily all refer to the same embodiment. Furthermore, particular features, structures, or characteristics may be appropriately combined in one or more embodiments of this specification.

It should be understood that in the foregoing description of the embodiments of this specification, to aid in understanding a feature and for the purpose of simplifying this specification, various features are combined in a single embodiment, drawing, or description thereof. However, this does not mean that the combination of these features is necessary, and it is entirely possible for a person skilled in the art, upon reading this specification, to identify some of the features as separate embodiments for understanding. That is to say, the embodiments in this specification can also be understood as an integration of multiple sub-embodiments. This holds true even when the content of each sub-embodiment includes fewer than all the features of a single foregoing disclosed embodiment.

Each patent, patent application, publication of a patent application, and other materials, such as articles, books, specifications, publications, documents, articles, etc., cited herein, except for any historical prosecution documents to which it relates, which may be inconsistent with or any identities that conflict, or any identities that may have a restrictive effect on the broadest scope of the claims, are hereby incorporated by reference for all purposes now or hereafter associated with this document. Furthermore, in the event of any inconsistency or conflict between the description, definition, and/or use of a term associated with any contained material, the term used in this document shall prevail.

Finally, it should be understood that the embodiments of the application disclosed herein are illustrative of the principles of the embodiments of this specification. Other modified embodiments are also within the scope of this specification. Therefore, the embodiments disclosed in this specification are merely examples and not limitations. A person skilled in the art may adopt alternative configurations based on the embodiments in this specification to implement the application in this specification. Accordingly, the embodiments of this specification are not limited to the embodiments precisely described in the application.

## Claims

1. An audio processing device, **characterized in that** the audio processing device comprises:
a sound-emitting module, comprising N sound-emitting units, wherein each of the sound-emitting units outputs an audio signal of a predetermined frequency band during operation, wherein N is an integer greater than 1; and
an audio processing module, in communication with the sound-emitting module, wherein the audio processing module is configured to:
obtain initial audio data,
perform frequency division processing on the initial audio data to obtain at least M sub-audio data of corresponding M sub-frequency bands, wherein each sub-frequency band corresponds to the predetermined frequency band output by corresponding sound-emitting unit among the N sound-emitting units, wherein M is an integer greater than 1,
perform audio adjustment on each of the corresponding M sub-audio data according to target audio characteristics of the M sub-audio data to obtain M adjusted audio data, and
input each adjusted audio data of the M adjusted audio data to the corresponding sound-emitting unit respectively.

2. The audio processing device according to claim 1, **characterized in that** to perform the audio adjustment on the M sub-audio data respectively, the audio processing module is configured to, for each of the sub-audio data:
perform the audio adjustment on the sub-audio data according to an audio adjustment model corresponding to the target audio characteristics of the sub-audio data, wherein the audio adjustment model corresponds to the sub-frequency band in which the sub-audio data is located.

3. The audio processing device according to claim 2, **characterized in that** the target audio characteristics comprise volume gain; before performing the audio adjustment on the sub-audio data, the audio processing module is further configured to:
obtain a volume gain of the sub-audio data of the sub-frequency band; and
determine the audio adjustment model corresponding to the sub-audio data of the sub-frequency band according to a correspondence between the volume gain and the audio adjustment model.

4. The audio processing device according to claim 3, **characterized in that** the volume gain comprises a plurality of volume levels, and different volume levels among of the plurality of volume levels correspond to different audio adjustment models.

5. The audio processing device according to claim 2, **characterized in that** the audio processing module is further configured to, for each sub-frequency band in the M sub-frequency bands:
obtain adjusted audio data of a predetermined time length as sample data;
compare audio data of the sample data with reference audio data, wherein the reference audio data is audio data corresponding to a reference audio curve of the audio adjustment model corresponding to the sub-frequency band; and
adjust a model parameter of the audio adjustment model according to a comparison result.

6. The audio processing device according to claim 5, **characterized in that** the audio processing module is further configured to:
obtain an update backup corresponding to the reference audio data of the audio adjustment model, and update the reference audio data according to the update backup.

7. The audio processing device according to any one of claims 2 to 6, **characterized in that** the audio adjustment model is an equalizer adjustment model, and the model parameter is an equalizer parameter.

8. The audio processing device according to claim 1, **characterized in that** the N sound-emitting units comprise a bone conduction sound-emitting unit and an air conduction sound-emitting unit, wherein the bone conduction sound-emitting unit outputs mid-high frequency audio signals during operation, and the air conduction sound-emitting unit outputs low-frequency audio signals during operation.

9. The audio processing device according to claim 1, **characterized in that** the initial audio data comprise audio data of K channels, and a frequency band interval of each channel comprises m sub-frequency bands, wherein m=M/K, and K is an integer greater than or equal to 1.

10. The audio processing device according to claim 9, **characterized in that** the K channels comprise a left channel and a right channel, the m sub-frequency bands corresponding to the left channel comprise left channel mid-high frequencies and left channel low frequencies, and the m sub-frequency bands corresponding to the right channel comprise right channel mid-high frequencies and right channel low frequencies.

11. The audio processing device according to claim 9, **characterized in that** a correspondence between channels and sound-emitting units comprises at least one of a one-to-many relationship, or a many-to-one relationship.

12. The audio processing device according to claim 1, **characterized in that** the audio processing device is a headphone.

13. An audio processing method, **characterized in that** the method is applied to an audio processing device, the audio processing device comprises N sound-emitting units, each of the sound-emitting units is configured to output an audio signal of a predetermined frequency band, wherein N is an integer greater than 1, the method comprising:
obtain initial audio data;
perform frequency division processing on the initial audio data to obtain at least M sub-audio data corresponding to M sub-frequency bands, wherein each sub-frequency band corresponds to the predetermined frequency band output by a corresponding sound-emitting unit among the N sound-emitting units, and M is an integer greater than 1;
perform audio adjustment on the M sub-audio data according to target audio characteristics of the M sub-audio data to obtain M adjusted audio data; and
input each adjusted audio data of the M adjusted audio data to the corresponding sound-emitting unit respectively.

14. The method according to claim 13, **characterized in that** the performing of the audio adjustment on the M sub-audio data respectively comprises, for each sub-audio data:
performing the audio adjustment on the sub-audio data according to the audio adjustment model corresponding to the target audio characteristics of the sub-audio data, wherein the audio adjustment model corresponds to the sub-frequency band where the sub-audio data is located.

15. The method according to claim 14, **characterized in that** the target audio characteristics comprise volume gain; before performing the audio adjustment on the sub-audio data, the method further comprises:
obtaining a volume gain of the sub-audio data of the sub-frequency band; and
determining the audio adjustment model corresponding to the sub-audio data of the sub-frequency band according to a correspondence between the volume gain and the audio adjustment model.

16. The method according to claim 15, **characterized in that** the volume gain comprises a plurality of volume levels, and different volume levels among of the plurality of volume levels correspond to different audio adjustment models.

17. The method according to claim 14, **characterized in that** the method further comprises: for each sub-frequency band in the M sub-frequency bands:
obtaining adjusted audio data of a predetermined time length as sample data;
comparing audio data of the sample data with reference audio data, wherein the reference audio data is audio data corresponding to a reference audio curve of the audio adjustment model corresponding to the sub-frequency band; and
adjusting a model parameter of the audio adjustment model according to a comparison result.

18. The method according to claim 17, **characterized in that** the audio adjustment model is an equalizer adjustment model, and the model parameter is an equalizer parameter.

19. The method according to claim 13, **characterized in that** the N sound-emitting units comprise a bone conduction sound-emitting unit and an air conduction sound-emitting unit, wherein the bone conduction sound-emitting unit outputs mid-high frequency audio signals during operation, and the air conduction sound-emitting unit outputs low-frequency audio signals during operation.

20. The method according to claim 13, **characterized in that** the initial audio data comprise audio data of K channels, and a frequency band interval of each channel comprises m sub-frequency bands, wherein m=M/K, and K is an integer greater than or equal to 1.

21. The method according to claim 20, **characterized in that** the K channels comprise a left channel and a right channel, the m sub-frequency bands corresponding to the left channel comprise left channel mid-high frequencies and left channel low frequencies, and the m sub-frequency bands corresponding to the right channel comprise right channel mid-high frequencies and right channel low frequencies.
